# EUROPEAN PATENT SPECIFICATION

(11) **EP 1 739 442 B1**
(45) Date of publication and mention of the grant of the patent: **09.12.2009**
(21) Application number: 05014047.4
(22) Date of filing: 29.06.2005
(51) Int. Cl.: G01R 31/28

(54) **A chamber for processing electronic devices**
Kammer zur Bearbeitung elektronischer geräte
Chambre pour le traitement d'appareils electroniques

(43) Date of publication of application: 03.01.2007
(73) Proprietor: SwissQual License AG, 4528 Zuchwil (CH)
(72) Inventor: Bobst, Hanspeter, 4702 Oensingen (CH)
(74) Representative: Blum, Rudolf Emil

(56) References cited:
- US-A1- 2002 092 357
- US-A1- 2002 160 717
- US-B1- 6 313 442

## Description

The invention relates to a device for assessing the quality of a mobile phone and/or mobile phone network.

To characterize the quality and performance of a mobile phone network, a mobile phone is conventionally placed in a suitable test device and brought into different locations within the network. At each location, the quality of communication is tested and logged. Similar test devices can also be used to test the quality of a mobile phone.

Patent document US-B1-6 313 442 discloses a portable heating tent for testing telecommunications equipment. The heating tent comprises a heater/blower assembly and provides a housing with a housing frame. The housing frame has a first housing section sized to contain telecommunications equipment for testing and a second housing section in form of a support area for holding the heater/blower assembly. The blower of the heater/blower assembly is via an adapter in form of a boot directly connected to an inlet of the first housing section for air supply. The heater/blower assembly is further directly connected to an outlet of the first housing section via a metal section. There is no air forced through the support area.

Patent application US 2002/160717 A1 discloses a chamber for testing several mobile phones placed on a conveyor belt. A camera is provided that is connected to a vision camera interface.

The problem to be solved by the present invention is to provide a test device of this type with improved reliability.

This problem is solved by the device of claim 1. Accordingly, the device is equipped with a housing and a heater for heating air in the housing. Even though test devices of this type are generally cooled rather than heated, it has been found that the ability to heat the environment of the phone inside the housing improves reliability because the quality of performance of many phones tends to degrade quickly when temperatures become too low. Hence, the device according to the invention works more reliable, in particular under low temperature or high humidity conditions.

The proposed design is particularly advantageous when being used in a device that has a camera and imaging optics for recording the phone's display because a slight heating of the air can prevent condensation to form on the surfaces of the phone's display, on the imaging optics or on the camera.

Further advantageous embodiments and applications of the invention are disclosed in the dependent claims as well as in the following description, which makes reference to the annexed figures, wherein:
Fig. 1 is a three dimensional view of an embodiment of the device with one side wall removed,
Fig. 2 is a three dimensional sectional view in a vertical plane along line II-II of Fig. 1,
Fig. 3 is a two dimensional sectional view along line II-II of Fig. 1,
Fig. 4 is the device of Fig. 3 modified to receive a phone with hinged display,
Fig. 5 is an algorithm for no-reference video quality assessment, and
Fig. 6 an alternative arrangement of the phone inside the device.

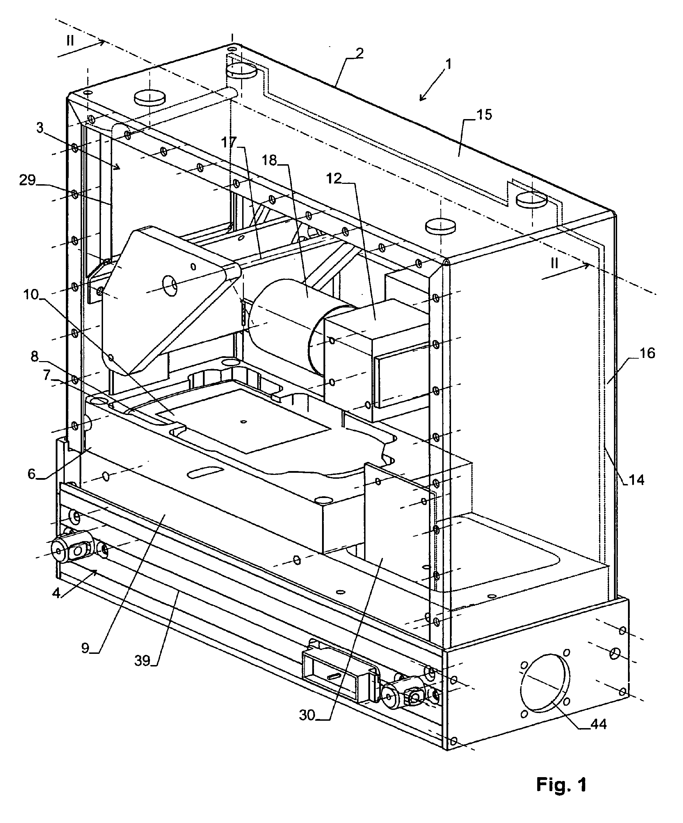

Figs. 1 - 3 show a device 1 for testing mobile phones and their reception in a mobile phone network. The device comprises a housing 2 divided into a first, upper housing section 3 and a second, lower housing section 4.

A phone holder 6 is arranged in upper housing section 3. In the present embodiment, it is formed by a frame-like structure surrounding a central opening or recess 7 shaped to receive a phone 8 in a well defined position and orientation. Phone holder 6 is a modular part that can be replaced easily. Differently shaped phone holders 6 can be provided for different types and brands of phones. Phone holder 6 is mounted on a frame structure 9 in the bottom part of upper housing section 3.

The phone 8 shown in Fig. 1 is a device with an integrated display 10. It is placed in phone holder 6 in such a way that display 10 is facing upwards.

To monitor the quality of an image or video on display 10, a camera 12 is arranged in upper housing section 3. Camera 12 is mounted to a mount formed by two vertical plates 14 resting on frame structure 9, one of which is indicated in dashed lines in Fig. 1, with the other being parallel thereto arranged at the opposite side of the device. At their upper ends, the vertical plates 14 are connected to a top wall plate 15 of upper housing section 3, which in turn is connected to four vertical wall plates 16, thereby forming a rigid structure for keeping the relative position between camera 12 and display 10 fixed even when the device is exposed to movements, e.g. while it is being driven or walked through a mobile phone network.

Imaging optics comprising a mirror 17 and a camera objective 18 project the light from display 10 onto the photo-sensitive array of camera 12, which allows to view the image or video data displayed on display 10 by means of the camera.

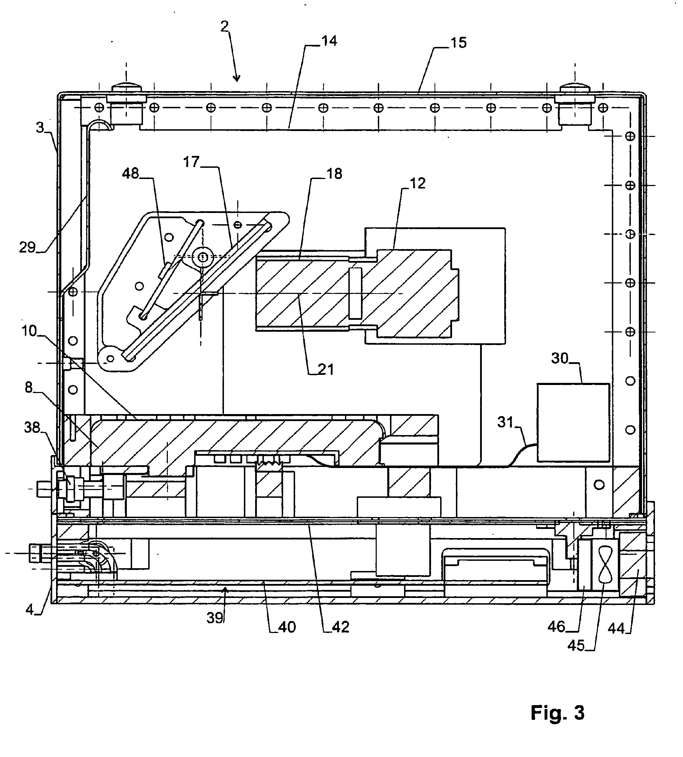

As can best be seen in Fig. 3, mirror 17 is arranged under an angle of approximately 45°, such as between 30° and 60°, in respect to the surface of display 10. It reflects the light coming from display 10 into the direction of the axis 21 of camera 12. Camera axis 21 is substantially parallel to the surface of display 10 and to the longitudinal axis of mobile phone 8.

As mentioned above, mirror 17 folds the projection path of the imaging optics, thereby allowing to create a more compact device that takes less space and is mechanically more stable.

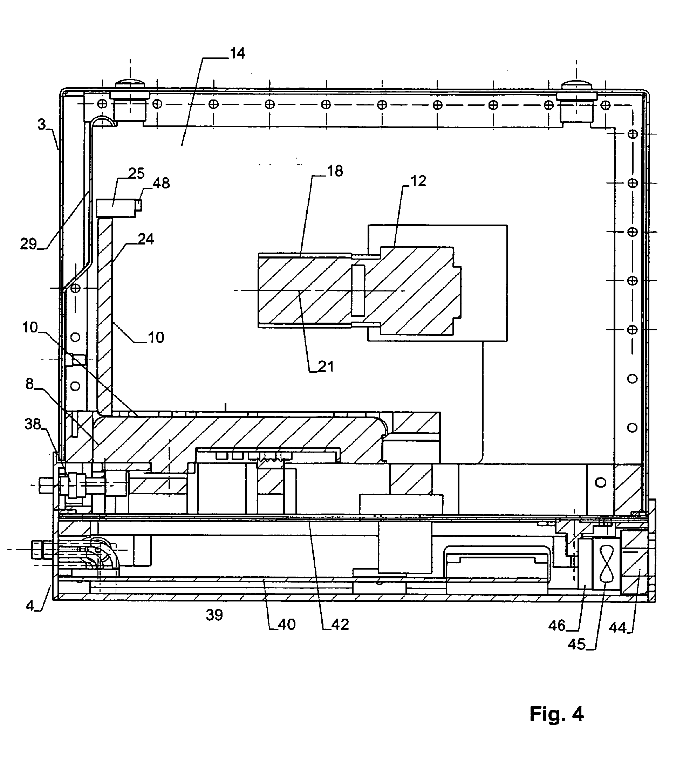

A second advantage of using a design with folded projection path is the fact that, by removing mirror 17, it becomes possible to use the same basic design for testing a phone with hinged display, such as it is shown in Fig. 4. The device of Fig. 4 is being used for a phone the display 10 of which is in a separate display housing 24 pivotally attached to the body of phone 8. To allow camera 12 to view display 10 of the phone, display housing 24 is pivoted such that display 10 is substantially vertical and stands perpendicularly to camera axis 21. A retainer 25 e.g. mounted to vertical plate 14 is used to keep display housing 24 in its vertical position.

Turning now back to Figs. 1 - 3, it can be seen that there is a number of objects arranged in upper housing section 3, all of which can potentially reflect the diffuse light coming from display 10. To avoid undesired noise from such reflected light in the signal of camera 12, all components within upper housing sections 3 with the exception of the imaging optics 17, 18 and the mobile phone 8 should have black, non-reflecting surfaces. This is in particular true for the walls 15, 16 and the vertical plates 14.

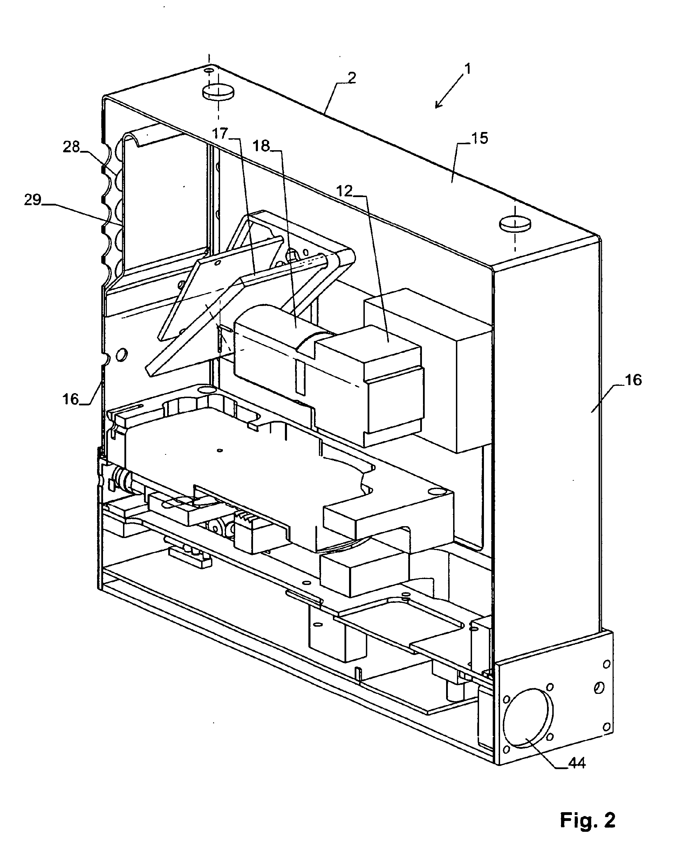

In addition, and as best can be seen in Fig. 2, upper housing section 3 has a number of ventilation openings 28 in one of the vertical walls 16. These ventilation openings carry off heat generated by the device 1 and the phone 8. To prevent light ne entering ventilation openings 28 from reaching camera 12, at least one light baffle plate 29 is arranged in front of the openings 28 for forming a labyrinth preventing light from entering upper housing section 3. Baffle plate 29 is non-transparent plastic or metal plate. To further improve the light retention properties of the labyrinth, several baffle plates can be arranged behind each other, forming a meandering path for passage of the ventilation air between them.

When using device 1, it may frequently be necessary to change some characteristics on the SIM card of phone 8, e.g. for switching between different network providers. To simplify this process, a SIM card holder 30 externally to phone 8 is arranged in upper housing section 3. A connector 31, as shown in Fig. 3, is provided to connect SIM card holder 30 to a dummy SIM card placed in the SIM card bay of phone 8, thereby connecting a SIM in SIM card holder 30 to phone 8. This makes it possible to replace the SIM card without removing phone 8 from phone holder 6.

Upper housing section 3, and in particular the walls 15, 16 as well as the vertical plates 14, can be made of a plastic or metal. If they are of a conductive material, they may hinder radiowave communication between phone 8 and a mobile phone network.

To ensure proper communication between phone 8 and the network, upper housing section 3 is therefore, in one embodiment, at least partially of plastics for allowing radiowave communication between phone 8 in holder 6 and the mobile phone network. In particular, the walls 15, 16 as well as the vertical plates 14 are, in that case, advantageously made from a sturdy plastic material.

Alternatively, and as shown in particular in Fig. 3, a lead-through 38 may be provided for connecting phone 8 in phone holder 6 to an external antenna.

The signals from camera 12 must be processed by suitable control and processing circuitry. This circuitry is preferably integrated, at least in part, in device 1.

In the embodiment of Figs. 1 - 3, most parts of the control and processing circuitry 39 are located on a PCB in lower housing section 4. In an advantageous embodiment, the control and processing circuitry 39 forms an image processing computer for evaluating the quality of the image or video from camera 12 connected to it.

Control and processing circuitry 39 further comprises electronic components and software for controlling and monitoring the operation of phone 8. In particular, it is connected to a digital interface of the phone, which allows the circuitry to issue commands to the phone and to receive status information therefrom. It may also contain an interface to an audio output of phone 8.

To prevent RF noise generated by processing circuitry 39 from interfering with the operation of phone 8, an RF shielding 42 is arranged between the two housing sections 3, 4, separating phone holder 8 from processing circuitry 39.(In this context, "RF noise" designates any electromagnetic noise in a frequency range above 1 MHz and in particular in the frequency range of communication that mobile phone networks are using.)

RF shielding 42 can e.g. consist of a metallic net or punctured plate, which has openings for the passage of electric cables and ventilation air.

An air inlet opening 44 is arranged in lower housing section 4, connecting the same to the surroundings of device 1. A ventilator 45 and a heater 46, as schematically indicated in Fig. 3, are arranged at air inlet opening 44 for forcing air through housing 2 and, if necessary and as described below, for heating the same.

The air drawn in by ventilator 45 passes through heater 46, through lower housing section 4, where it carries off heat generated by control and processing circuitry 39, and then enters upper housing section 3, where it is used for heating or carrying off heat, depending on its temperature level. It then passes the gap above light baffle plate 29 and exits through the outlet openings 28.

To control the operation of the heater 46, a temperature sensor 48 is arranged in upper housing section 3. The temperature from temperature sensor 48 is monitored by control and processing circuitry 39 and heater 46 is switched on if the temperature in upper housing section 3 is below a preferred operating temperature of phone 8, e.g. at 20 °C. At least, heater 46 should be operated to keep the temperature in upper housing section 3 above 0 °C.

The advantage of heater 46 is two-fold: On the one hand, phone 8 and in particular its display 10 may fail if temperatures are too low. On the other hand, when heater 46 is being used in a test device that has a camera for monitoring the phone's display as described above, heating the incoming air reduces its relative humidity, thereby reducing the risk of water condensation on display 10 of phone 8, on imaging optics 17, 18, and/or on camera 12.

Instead of a single temperature sensor 48, several temperature sensors 48 can be provided, e.g. one close to display 10, one close to mirror 17 and one close to imaging optics 18, which allows to prevent the temperature of any of these parts from falling below a certain threshold of e.g. 20°C.

In Fig. 3, heater 46 is arranged in lower housing section 4 immediately after ventilator 45. It may also be arranged before ventilator 45, or it may be arranged further downstream, e.g. at a vent passage where the air passes from lower housing section 4 into upper housing section 3. Locating heater 46 such that it heats air after the same has passed control and processing circuitry 39 has the advantage that the circuitry can be cooled more efficiently and less energy is required for heating the air to a given temperature inside upper housing section 3.

Furthermore, it is possible to use more than one heater 46 for heating the components inside upper housing section 3.

Heater 46 can e.g. also be integrated in phone holder 6, in the holder of mirror 17, in the imaging optics 18 and/or in camera 12.

The algorithms to be used in control and processing circuitry 39 for analyzing the quality of the incoming image or video signal depend on if a "full reference", "reduced reference" or "no reference" analysis is to be carried out, i.e. if the original image or video (before it was transmitted over the network) is known fully, in part or not at all. Various such algorithms are known to the person skilled in the art and e.g. described in
- Z. Wang, A. C. Bovik, and B. L. Evans, "Blind measurement of blocking artifacts in images," in Proc. IEEE Int. Conf. Image Proc., vol. 3, Sept. 2000, pp. 981-984, or in
- H.R. Sheikh, Z. Wang, L.K. Cormack, and A.C. Bovik, "Blind Quality Assessment for JPEG2000 Compressed Images", Thirty-Sixth Annual Asilomar Conference on Signals, Systems, and Computers, Pacific Grove, California, November 3-6, 2002.

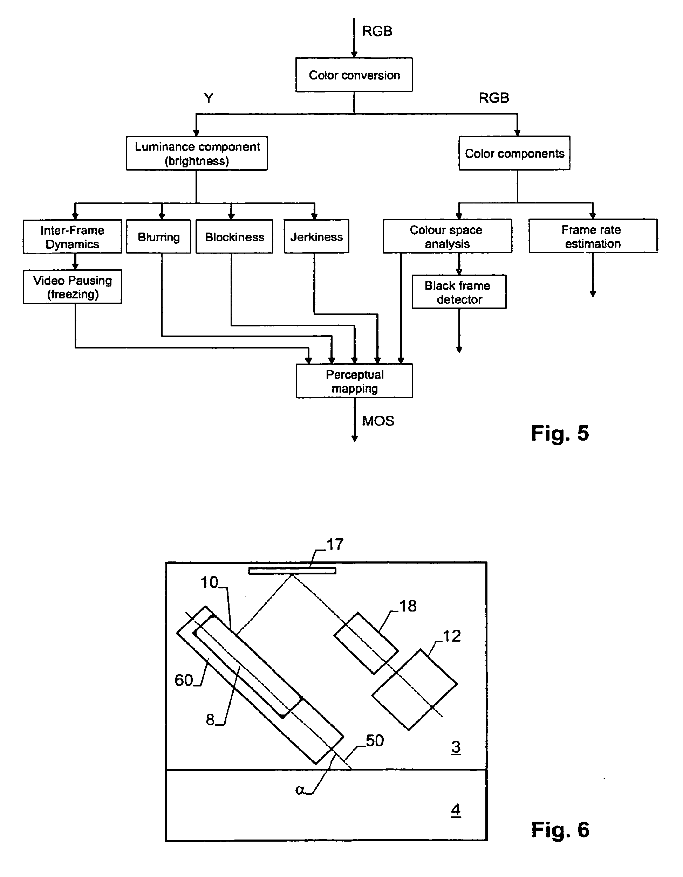

A specific example of an algorithm for a no-reference video quality assessment is shown in Fig. 5. It has the following processing steps:
- The input video signal is color converted to obtain a luminance signal Y and an RGB signal.
- The luminance Y and RGB signal are processed separately.
- Using the luminance Y signal, blurring, blockiness, jerkiness and inter frame (picture) dynamics are derived.
- The color signal allows to determine a parameter describing the colorfulness and to detect black frames.
- Perceptual mapping combines the results from the above analysis to a single quality number (MOS = Mean Opinion Score), which is a main result of the algorithm.

In order to avoid anti-aliasing problems, the resolution of camera 12 is advantageously sufficiently high such that each pixel of the projected part of display 10 is projected onto at least two horizontal and two vertical pixels of camera 12. This oversampling prevents data loss between display 10 and the signal of camera 12.

Similarly, data loss in time space can be avoided if the frame rate of the camera is at least equal to the frame rate of the display.

Depending on the section of display 10 that is projected onto camera 12, some parts of the recorded image may have to be filtered out before processing. For example, if the projected part of display 10 contains status information superimposing a video image, the areas containing the status information may have to be ignored.

Apart from assessing the quality of image or video data recorded by camera 12 from display 10, control and processing circuitry 39 may also derive information indicative of an operational status of phone 8 from the signal from camera 12. For example, if phone 8 displays a typical error message on display 10 in case of malfunction, this error message can be detected by suitably processing the image recorded by camera 12. Similarly, a malfunctioning camera may exhibit typical display behavior, such as a complete freeze or blackout of the display, which again can be detected by suitably processing the signal from camera 12. Generally, the signal from the camera 12 can be processed to detect an operational status and in particular a malfunctioning of the phone. Depending on the detected operational status, suitable commands can then be issued to the phone or the phone can be reset.

In the embodiment above, control and processing circuitry 39 is capable to fully process the signal from camera 12 and to create the relevant parameter's describing the quality of the image or video data. However, part of that functionality can also be delegated to an external computer.

In the embodiment of Figs. 1 - 4, the phone is arranged horizontally, i.e. with its longitudinal axis 50 parallel to RF shielding 42. As mentioned above, this may lead to an undesired interaction between the phone's antenna and RF shielding 42 if the phone's built-in antenna is used.

To avoid this problem, the phone can be arranged differently within housing 2. It may e.g. be arranged horizontally adjacent to top wall plate 15, with its display 10 facing downward, or it may be arranged adjacent to one of the side wall plates 16, in which case at least the corresponding wall plate 15 or 16, respectively, should be made from a non-conducting material.

Fig. 6 shows a further possible embodiment where holder 6 is arranged to hold phone 8 with its longitudinal axis at an angle α of approximately 45° to RF shielding 42. The mirror 17, imaging optics 18 and camera 12 have been rotated by the same amount. Hence, in this embodiment the end section of the phone 8 carrying display 10 is further away from RF shielding 42 than the opposite end section. Since the phone's antenna is generally arranged in the end section of the display, this arrangement again reduces possible undesired interactions between the antenna and RF shielding 42.

In the example above, device 1 determined the quality of reception from the image or video signal delivered by camera 12. Alternatively, it may also use raw digital image or video data obtained through a digital interface of phone 8. It might also use the phone's audio signal only, alone or in combination with video or image data.

Finally, even though a separate, dedicated heater 46 has been used in the examples above, the heater might also be formed in part or completely by the components of control and processing circuitry 39 if they give off a sufficient amount of heat. However, a separate, dedicated heater is advantageous because it can be controlled more easily.

## Claims

1. A device for assessing the quality of a mobile phone and/or mobile phone network comprising a housing (2) for receiving said mobile phone, a heater (46) for heating air in said housing (2) and a ventilator (45) for forcing air through said housing (2), wherein said housing (2) comprises a first and a second housing section (3, 4), wherein said phone (8) can be arranged in said first housing section (3), **characterized by** processing circuitry (39) for processing a video, image and/or audio signal received by the mobile phone (8), wherein said processing circuitry (39) is arranged in said second housing section (4), and wherein said ventilator (45) is positioned to first force said air through said second housing section (4) and then through said first housing section (3).

2. The device of claim 1 further comprising at least one temperature sensor (48) for monitoring a temperature in said housing and for controlling an operation of said heater (46).

3. The device of any of the preceding claims further comprising a camera (12) arranged in said housing and imaging optics (17, 18) for projecting at least part of a display of said phone onto said camera (12).

4. The device of any of the preceding claims wherein said housing sections are separated by an RF shielding (42).

5. The device of any of the preceding claims wherein said housing (2) comprises at least one ventilation opening (28) and at least one light baffle plate (29) arranged in front of said opening (28) for forming a labyrinth preventing light from entering said housing (2).

6. The device of any of the preceding claims wherein said device is adapted to keep a temperature in said housing at at least 0°C, in particular at at least 20°C, by operating said heater (46).

7. The device of any of the preceding claims wherein said heater (46) is separate from said processing circuitry (39).

## Patentansprüche

1. Eine Vorrichtung zum Beurteilen der Qualität eines Mobiltelefons und/oder eines Mobiltelefonnetzwerk umfassend ein Gehäuse (2) zum Aufnehmen von besagtem Mobiltelefon, eine Heizung (46) zum Heizen von Luft in besagtem Gehäuse (2) und einen Ventilator (45) zum Forcieren von Luft durch besagtes Gehäuse (2), wobei besagtes Gehäuse (2) einen ersten und einen zweiten Gehäuseabschnitt (3, 4) umfasst, wobei besagtes Telefon (8) in besagtem ersten Gehäuseabschnitt (3) anordnenbar ist, **gekennzeichnet durch** einen Verarbeitungsschaltkreis (39) zum Verarbeiten eines Videos, eines Bildes und/oder eines Audiosignals, welches von dem Mobiltelefon (8) empfangen worden ist, wobei besagter Verarbeitungsschaltkreis (39) in besagtem zweiten Gehäuseabschnitt (4) angeordnet ist, und wobei besagter Ventilator (45) positioniert ist, um besagte Luft zuerst **durch** besagten zweiten Gehäuseabschnitt (4) and dann **durch** besagten ersten Gehäuseabschnitt (3) zu forcieren.

2. Die Vorrichtung nach Anspruch 1 weiter umfassend zumindest einen Temperatursensor (48) zum Überwachen einer Temperatur in besagtem Gehäuse und zum Steuern eines Betriebs von besagter Heizung (46).

3. Die Vorrichtung nach einem der vorhergehenden Ansprüche weiter umfassend eine Kamera (12), die in besagtem Gehäuse angeordnet ist, und eine Abbildungsoptik (17, 18) zum Projizieren von zumindest einem Teil eines Displays von besagtem Telefon auf besagte Kamera (12).

4. Die Vorrichtung nach einem der vorhergehenden Ansprüche, wobei besagte Gehäuseabschnitte durch ein RF-Schild (42) getrennt sind.

5. Die Vorrichtung nach einem der vorhergehenden Ansprüche, wobei besagtes Gehäuse (2) zumindest eine Ventilationsöffnung (28) und zumindest eine Lichtumlenkplatte (29) umfasst, welche vor besagter Öffnung (28) angeordnet ist, um ein Labyrinth zu bilden, das verhindert, dass Licht in besagtes Gehäuse (2) eintritt.

6. Die Vorrichtung nach einem der vorhergehenden Ansprüche, wobei besagte Vorrichtung ausgebildet ist, eine Temperatur in besagtem Gehäuse durch Betreiben der Heizung (46) auf wenigstens 0°C, insbesondere auf wenigstens 20°C, zu halten.

7. Die Vorrichtung nach einem der vorhergehenden Ansprüche, wobei besagter Heizer (46) getrennt von besagtem Verarbeitungsschaltkreis (39) ist.

## Revendications

1. Dispositif pour vérifier la qualité d'un téléphone mobile et/ou d'un réseau de téléphonie mobile, comprenant un boîtier (2) pour recevoir ledit téléphone mobile, un élément chauffant (46) pour chauffer de l'air dans ledit boîtier (2) et un ventilateur (45) pour forcer de l'air à travers ledit boîtier (2), ledit boîtier (2) comprenant une première et une deuxième sections de boîtier (3, 4), ledit téléphone (8) pouvant être disposé dans ladite première section de boîtier (3), **caractérisé par** des circuits de traitement (39) pour traiter un signal vidéo, d'image et/ou audio reçu par le téléphone mobile (8), lesdits circuits de traitement (39) étant disposés dans ladite deuxième section de boîtier (4), et ledit ventilateur (45) étant positionné de façon à forcer tout d'abord ledit air à travers ladite deuxième section de boîtier (4), puis à travers ladite première section de boîtier (3).

2. Dispositif selon la revendication 1, comprenant de plus au moins un capteur de température (48) pour contrôler une température dans ledit boîtier et pour commander un fonctionnement dudit élément chauffant (46).

3. Dispositif selon l'une quelconque des revendications précédentes, comprenant de plus une caméra (12) disposée dans ledit boîtier et des optiques d'imagerie (17, 18) pour projeter au moins une partie d'un affichage dudit téléphone sur ladite caméra (12).

4. Dispositif selon l'une quelconque des revendications précédentes, dans lequel lesdites sections de boîtier sont séparées par un blindage pour hautes fréquences (42).

5. Dispositif selon l'une quelconque des revendications précédentes, dans lequel ledit boîtier (2) comprend au moins une ouverture de ventilation (28) et au moins une plaque d'écran de lumière (29) disposée devant ladite ouverture (28) pour former un labyrinthe empêchant la lumière d'entrer dans ledit boîtier (2).

6. Dispositif selon l'une quelconque des revendications précédentes, dans lequel ledit dispositif est adapté pour maintenir une température dans ledit boîtier à au moins 0° C, en particulier à au moins 20° C, par le fonctionnement dudit élément chauffant (46).

7. Dispositif selon l'une quelconque des revendications précédentes, dans lequel ledit élément chauffant (46) est séparé desdits circuits de traitement (39).
